(19) Europäisches Patentamt / European Patent Office / Office européen des brevets

(11) **EP 3 004 905 B1**

(12) **FASCICULE DE BREVET EUROPEEN**

(45) Date de publication et mention de la délivrance du brevet:
**02.10.2019 Bulletin 2019/40**

(21) Numéro de dépôt: **14731725.9**

(22) Date de dépôt: **26.05.2014**

(51) Int Cl.:
*G01R 31/36* (2019.01)    *G01R 31/367* (2019.01)
*G01R 31/389* (2019.01)    *G01R 31/392* (2019.01)

(86) Numéro de dépôt international:
**PCT/FR2014/051228**

(87) Numéro de publication internationale:
**WO 2014/195606 (11.12.2014 Gazette 2014/50)**

(54) **PROCÉDÉ POUR ESTIMER L'ÉTAT DE SANTÉ D'UNE CELLULE ÉLECTROCHIMIQUE DE STOCKAGE D'ÉNERGIE ÉLECTRIQUE**

VERFAHREN ZUR SCHÄTZUNG DES GESUNDHEITSZUSTANDES EINER ELEKTROCHEMISCHEN ZELLE ZUR SPEICHERUNG VON ELEKTRISCHER ENERGIE

METHOD FOR ESTIMATING THE STATE OF HEALTH OF AN ELECTROCHEMICAL CELL FOR STORING ELECTRICAL ENERGY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.06.2013 FR 1355092**

(43) Date de publication de la demande:
**13.04.2016 Bulletin 2016/15**

(73) Titulaire: **Renault S.A.S.**
**92100 Boulogne-Billancourt (FR)**

(72) Inventeurs:
• **DELOBEL, Bruno**
**75015 Paris (FR)**
• **SAINT-MARCOUX, Antoine**
**F-91120 Palaiseau (FR)**

(56) Documents cités:
**WO-A1-2011/050924     US-A1- 2002 196 027
US-A1- 2012 310 565**

• HU Y ET AL: "A technique for dynamic battery model identification in automotive applications using linear parameter varying structures", CONTROL ENGINEERING PRACTICE, PERGAMON PRESS, OXFORD, GB, vol. 17, no. 10, 1 octobre 2009 (2009-10-01), pages 1190-1201, XP026496900, ISSN: 0967-0661, DOI: 10.1016/J.CONENGPRAC.2009.05.002 [extrait le 2009-06-12]

• STANISLAV TAIROV ET AL: "Impedance measurements for battery state of health monitoring", CONTROL, INSTRUMENTATION AND AUTOMATION (ICCIA), 2011 2ND INTERNATIONAL CONFERENCE ON, IEEE, 27 décembre 2011 (2011-12-27), pages 79-83, XP032268132, DOI: 10.1109/ICCIAUTOM.2011.6356634 ISBN: 978-1-4673-1689-7

• KUEI-HSIANG CHAO ET AL: "State-of-health estimator based-on extension theory with a learning mechanism for lead-acid batteries", EXPERT SYSTEMS WITH APPLICATIONS, vol. 38, no. 12, 12 juin 2011 (2011-06-12), pages 15183-15193, XP028268655, ISSN: 0957-4174, DOI: 10.1016/J.ESWA.2011.05.084 [extrait le 2011-06-12]

• JONGHOON KIM ET AL: "State-of-Charge Estimation and State-of-Health Prediction of a Li-Ion Degraded Battery Based on an EKF Combined With a Per-Unit System", IEEE TRANSACTIONS ON VEHICULAR TECHNOLOGY, IEEE SERVICE CENTER, PISCATAWAY, NJ, US, vol. 60, no. 9, 1 novembre 2011 (2011-11-01), pages 4249-4260, XP011388447, ISSN: 0018-9545, DOI: 10.1109/TVT.2011.2168987

EP 3 004 905 B1

**Description**

La présente invention concerne un procédé pour estimer l'état de santé d'une cellule électrochimique de stockage d'énergie électrique. Elle s'applique notamment, mais pas exclusivement, aux véhicules automobiles électriques ou hybrides.

Dans le contexte actuel de consensus autour du réchauffement climatique, la diminution des émissions de dioxyde de carbone ($CO_2$) est un défi majeur auquel sont confrontés les constructeurs automobiles, les normes étant toujours plus exigeantes en la matière.

Outre l'amélioration constante des rendements des moteurs thermiques classiques, qui s'accompagne d'une baisse des émissions de $CO_2$, les véhicules électriques (« EV » d'après la terminologie anglo-saxonne « Electric Vehicle ») et les véhicules hybrides thermique-électrique (« HEV » d'après la terminologie anglo-saxonne « Hybrid Electric Vehicle ») sont aujourd'hui considérés comme la solution la plus prometteuse pour diminuer les émissions de $CO_2$.

Différentes technologies de stockage de l'énergie électrique ont été testées dans les dernières années afin de répondre aux besoins des EV. Il apparaît aujourd'hui que les batteries à cellules lithium-ion (Li-ion) sont celles qui permettent d'obtenir le meilleur compromis entre la densité de puissance, qui favorise les performances en termes d'accélération notamment, et la densité d'énergie, qui favorise l'autonomie.

Malheureusement, la densité de puissance et la densité d'énergie diminuent tout au long de la vie de la batterie, notamment sous l'effet des variations de température. Ainsi, après un délai d'utilisation suffisamment long, un EV peut présenter des performances dégradées en termes d'autonomie et/ou de puissance. Il convient de contrôler cette dégradation, afin de maintenir des niveaux de prestation et de sécurité suffisants.

Afin de quantifier cette dégradation, un indicateur appelé « Etat de Santé » (« SOH » d'après la terminologie anglo-saxonne « State Of Health ») a été défini, qui est le ratio de la capacité courante d'une batterie par rapport à sa capacité initiale en début de vie. Il est connu, notamment du brevet US6653817, d'estimer le SOH à partir de l'estimation par impédancemétrie de la résistance interne de la batterie (ou « DCR » d'après la terminologie anglo-saxonne « Direct Current Résistance »). La résistance interne d'une batterie caractérisant la variation de la tension U aux bornes de la batterie pour une certaine variation de l'intensité I du courant traversant la batterie, ce brevet propose de piloter finement la variation de l'intensité I traversant la batterie et de mesurer la variation de la tension U aux bornes de la batterie. Un inconvénient majeur de cette solution est que si la mesure de tension n'est pas précise, notamment en cas de bruits transitoires, l'estimation de la résistance peut être impactée et l'estimation du SOH peut être imprécise. Il s'agit de l'un des problèmes que la présente invention se propose de résoudre.

Le document US2012/0310565 divulgue un procédé pour estimer l'état de santé d'une cellule électrochimique de stockage d'énergie électrique, le procédé comportant une étape d'application à la cellule d'au moins un pic de courant traversant la cellule; une étape de mesure de la variation, en fonction du temps t s'écoulant après l'application du pic de courant, de la tension aux bornes de la cellule; et une étape de calcul des coefficients tels que la fonction log t → tension est une approximation linéaire de la variation de la tension en fonction de log t.

L'invention a notamment pour but de résoudre les inconvénients précités, notamment d'éviter les problèmes de mesure, ceci en linéarisant la mesure de la résistance interne. A cet effet, l'invention a pour objet un procédé pour estimer l'état de santé d'une cellule électrochimique de stockage d'énergie électrique. Il comporte une étape d'application à la cellule d'au moins un pic de courant d'intensité $I_1$, le pic de courant traversant la cellule. Il comporte également une étape de mesure de la variation, en fonction du temps $t$ s'écoulant après l'application du pic de courant, de la tension U aux bornes de la cellule. Il comporte également une étape de calcul d'au moins un coefficient $\alpha_{I_1}$ et d'au moins un coefficient $U_{0,I_1}$ tels que la fonction $\sqrt{t} \rightarrow \alpha_{I_1} \times \sqrt{t} + U_{0,I_1}$ est une approximation linéaire de la variation de la tension U en fonction de $\sqrt{t}$ pour $\sqrt{t} \geq C$, où $C > 0$.

Dans un mode de réalisation, les coefficients $\alpha_{I_1}$ et $U_{0,I_1}$ peuvent être calculés une première fois en début de vie de la cellule. Le procédé peut alors comporter une étape de calcul du ratio de la valeur couramment calculée de $\alpha_{I_1}$ par rapport à sa valeur calculée en début de vie, une augmentation du coefficient $\alpha_{I_1}$, au-delà d'une valeur prédéterminée pouvant indiquer une incapacité de la cellule à délivrer un courant dans ses gammes de puissance les plus élevées. Le procédé peut également comporter une étape de calcul du ratio de la valeur couramment calculée de $U_{0,I_1}$ par rapport à sa valeur calculée en début de vie, une augmentation du coefficient $U_{0,I_1}$ au-delà d'une valeur prédéterminée pouvant indiquer une incapacité de la cellule à délivrer un courant dans ses gammes de puissance les plus élevées.

Dans un autre mode de réalisation, des tables ou des graphes de vieillissement peuvent être remplies au préalable. Le procédé peut alors comporter une étape de comparaison de la valeur couramment calculée de $\alpha_{I_1}$ avec des valeurs contenues dans une table ou un graphe de vieillissement associant des niveaux de vieillissement à des valeurs de $\alpha_{I_1}$, de manière à déduire le niveau de vieillissement de la cellule. Le procédé peut également comporter une étape de comparaison de la valeur couramment calculée de $U_{0,I_1}$ avec des valeurs contenues dans une table ou un graphe de vieillissement associant des niveaux de vieillissement à des valeurs de

$U_{0,I_1}$, de manière à déduire le niveau de vieillissement de la cellule.

Dans un mode de réalisation préférentiel, une pluralité de pics de courant d'intensités $(I_n)_{n\geq2}$ peuvent être appliqués à la cellule $(I_1,I_2,I_3,I_4,I_5)$. Le procédé peut alors comporter une étape de calcul d'un coefficient $\beta$ tel que la fonction $I \rightarrow \beta \times I$ est une approximation linéaire de la variation de $\Delta U / \sqrt{t}$ en fonction de $I$.

Dans un autre mode de réalisation, le coefficient $\beta$ peut être calculé une première fois en début de vie de la cellule. Le procédé peut alors comporter une étape de calcul du ratio de la valeur couramment calculée de $\beta$ par rapport à sa valeur calculée en début de vie, une augmentation du coefficient $\beta$ au-delà d'une valeur prédéterminée pouvant indiquer une incapacité de la cellule à délivrer un courant dans ses gammes de puissance les plus élevées.

Dans un autre mode de réalisation préférentiel, des tables ou des graphes de vieillissement peuvent être remplies au préalable. Le procédé peut alors comporter une étape de comparaison de la valeur couramment calculée de $\beta$ avec des valeurs contenues dans une table ou un graphe de vieillissement associant des niveaux de vieillissement à des valeurs de $\beta$, de manière à déduire le niveau de vieillissement de la cellule.

Dans un mode de réalisation préférentiel, le procédé peut comporter une étape de calcul d'un coefficient $\gamma$ tel que la fonction $I \rightarrow \gamma \times I + OCV$, où OCV est la tension en circuit ouvert de la cellule (« Open Circuit Voltage » selon la terminologie anglo-saxonne), est une approximation linéaire de la variation de $U_{0,I}$ en fonction de $I$.

Dans un mode de réalisation, le coefficient $\gamma$ peut être calculé une première fois en début de vie de la cellule. Le procédé peut alors comporter une étape de calcul du ratio de la valeur couramment calculée de $\gamma$ par rapport à sa valeur calculée en début de vie, une augmentation du coefficient $\gamma$ au-delà d'une valeur prédéterminée pouvant indiquer une incapacité de la cellule à délivrer un courant dans ses gammes de puissance les plus élevées.

Dans un mode de réalisation préférentiel, des tables ou des graphes de vieillissement peuvent être remplies au préalable. Le procédé peut alors comporter une étape de comparaison de la valeur couramment calculée de $\gamma$ avec des valeurs contenues dans une table ou un graphe de vieillissement associant des niveaux de vieillissement à des valeurs de $\gamma$, de manière à déduire le niveau de vieillissement de la cellule.

La présente invention a encore pour principal avantage qu'elle ne nécessite que la mise à jour logicielle des dispositifs actuels d'estimation de l'état de santé d'une batterie.

D'autres caractéristiques et avantages de l'invention apparaîtront à l'aide de la description qui suit faite en regard de dessins annexés qui représentent :

- la figure 1, par un graphe, un exemple de variation en fonction du temps $t$ après application d'un pic de courant d'intensité de la tension $U$ aux bornes d'une cellule Li-ion ;
- la figure 2, par un graphe, la variation de $U$ en fonction de $\sqrt{t}$ ;
- la figure 3, par un graphe, différents exemples de variation de $U$ en fonction de $\sqrt{t}$ pour différents pics de courant ;
- la figure 4, par un graphe, la variation de $\Delta U / \sqrt{t}$ en fonction de l'intensité I ;
- la figure 5, par un graphe, la variation en fonction de $I$ d'un coefficient selon l'invention ;
- les figures 6, 7, 8 et 9, des graphes de vieillissement selon l'invention.

La présente invention propose de calculer différents coefficients caractéristiques de l'état de santé d'une cellule Li-ion.

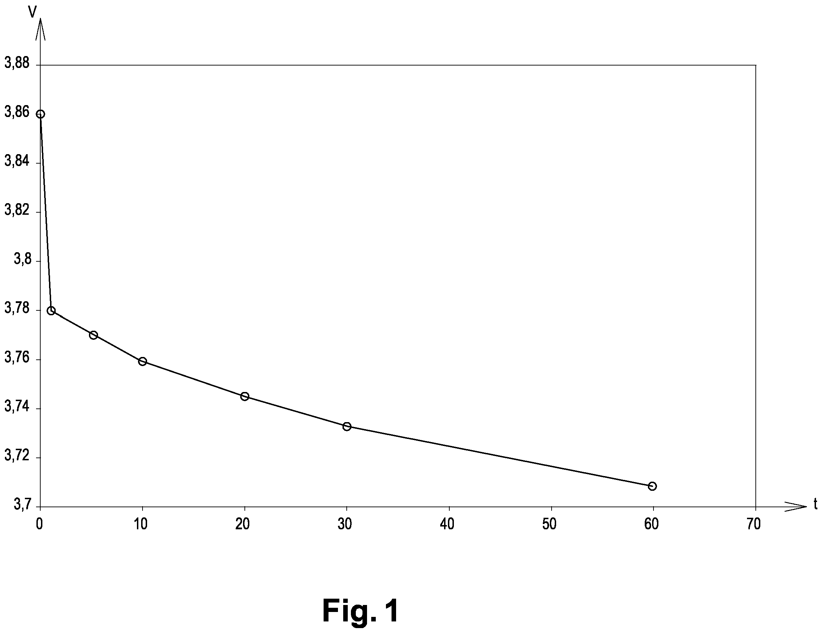

Comme illustré dans l'exemple de la figure 1, la tension U aux bornes d'une cellule Li-ion ayant un niveau de charge de l'ordre de 40% peut, après qu'un pic de courant d'intensité $I_1$ = 74 A (ampères) ait traversé cette cellule à un instant t=0, évoluer de t=0 à t=60 secondes conformément au graphe illustré par cette figure. A partir de cette simple courbe représentant la variation de $U$ en fonction du temps $t$, il est possible selon l'invention d'extraire divers coefficients directement reliés à la capacité de la cellule à fonctionner à forte densité de puissance, cette capacité étant désignée « $SOH_P$ » dans la suite de la présente demande, par opposition à sa capacité à fonctionner à forte densité d'énergie qui sera désignée « $SOH_E$ ».

Dans l'exemple de la figure 1, la tension aux bornes de la cellule décroît de 3,86V à t=0s jusqu'à 3,71V à t=60s de manière clairement non linéaire. La valeur initiale de tension à 3,86V correspondant à la tension aux bornes de la cellule en circuit ouvert, c'est-à-dire lorsque la cellule n'est pas traversée par un courant, cette tension étant couramment désignée par l'acronyme anglo-saxon « OCV » signifiant « Open Circuit Voltage ».

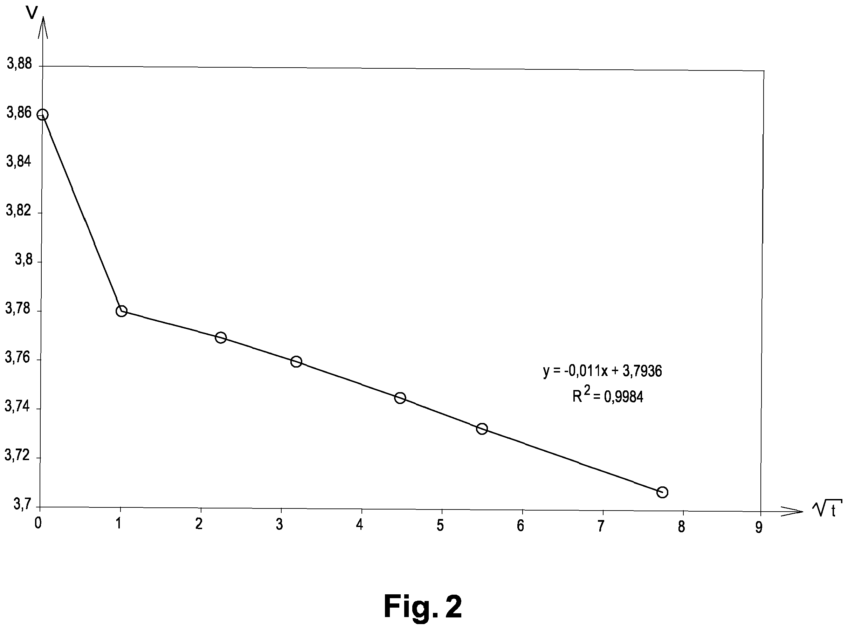

La figure 2 illustre, en fonction de $\sqrt{t}$ et non plus en fonction de t, l'évolution de la même tension U après que le pic de courant d'intensité $I_1$ ait traversé la cellule. On constate que, à partir de $\sqrt{t} = 1$, la tension décroît linéairement en fonction de $\sqrt{t}$. Et en effet, une méthode de linéarisation montre que la variation de $U$ en fonction de $\sqrt{t}$ peut être approchée, pour $\sqrt{t} \geq 1$, par la droite d'équation

$$U = \alpha_{I_1} \times \sqrt{t} + U_{0,I_1}$$ de pente $\alpha_{I1}$ = -0,011 et d'ordonnée à l'origine $U_{0,I_1}$ = 3,7936, ceci avec un coefficient de corrélation $R^2$ = 0,9984.

Pour un courant I donné, la pente $\alpha_I$ donne une indication sur le $SOH_P$ de la cellule, notamment sur sa capacité à fonctionner sur des temps longs supérieurs à 1 seconde à un courant donné.

Pour un courant I donné, l'ordonnée à l'origine $U_{0,I}$ donne également une indication sur le $SOH_P$ de la cellule, en particulier :

- plus $U_{0,I}$ est important par rapport à l'OCV, moins la cellule est apte à fonctionner à haute puissance de l'ordre de 100 à 1000 watts.;
- une ordonnée à l'origine $U_{0,I}$ important par rapport à l'OCV peut aussi indiquer que la cellule a un problème à des temps courts, c'est-à-dire à hautes fréquences, comme des problèmes de connectique ou de soudure.

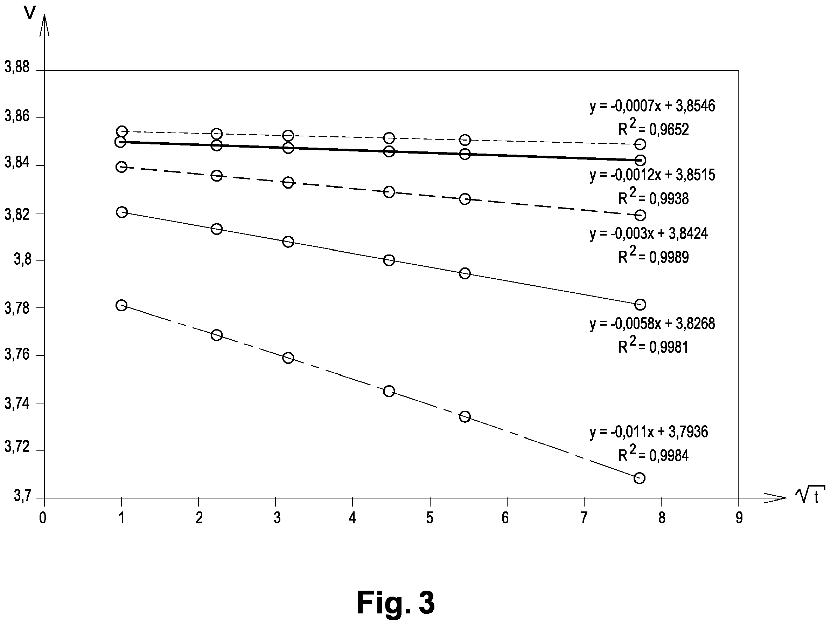

Optionnellement, il est possible de mettre en oeuvre une stratégie de diagnostic de l'état de santé à plusieurs courants selon la présente invention, comme illustré par les figure 3, 4 et 5 qui suivent, cette stratégie permettant un diagnostic plus affiné.

En effet, la figure 3 illustre en fonction de $\sqrt{t}$ l'évolution de la tension U aux bornes de la même cellule ayant un niveau de charge de l'ordre de 40%, non seulement après que le pic de courant d'intensité $I_1$ = 74 A ait traversé la cellule, mais également après que 4 autres pics d'intensités respectives $I_2$ = 37 A, $I_3$ = 18,5A, $I_4$ = 7,4A et $I_5$ = 3,7A aient traversé cette même cellule. Là encore, quel que soit le pic considéré, on constate que, à partir de $\sqrt{t} = 1$, la tension décroît linéairement en fonction de $\sqrt{t}$. La même méthode de linéarisation montre que les variations des tensions en fonction de $\sqrt{t}$ peuvent être approchées, pour $\sqrt{t} \geq 1$ :

- après le pic d'intensité $I_2$, par la droite d'équation

$$U = \alpha_{I_2} \times \sqrt{t} + U_{0,I_2}$$ de pente $\alpha_{I2}$ = -0,0058 et d'ordonnée à l'origine $U_{0,I_2}$ = 3,8268, ceci avec un coefficient de corrélation $R^2$ = 0,9981 ;
- après le pic d'intensité $I_3$, par la droite d'équation

$$U = \alpha_{I_3} \times \sqrt{t} + U_{0,I_3}$$ de pente $\alpha_{I3}$ = -0,003 et d'ordonnée à l'origine $U_{0,I_3}$ = 3,8424, ceci avec un coefficient de corrélation $R^2$ = 0,9989 ;
- après le pic d'intensité $I_4$, par la droite d'équation

$$U = \alpha_{I_4} \times \sqrt{t} + U_{0,I_4}$$ de pente $\alpha_{I4}$ = -0,0012 et

d'ordonnée à l'origine $U_{0,I4}$ = 3,8515, ceci avec un coefficient de corrélation $R^2$ = 0,9938 ;
- après le pic d'intensité $I_5$, par la droite d'équation

$$U = \alpha_{I_5} \times \sqrt{t} + U_{0,I_5}$$ de pente $\alpha_{I5}$ = -0,0007 et d'ordonnée à l'origine $U_{0,I_5}$ = 3,8546, ceci avec un coefficient de corrélation $R^2$ = 0,9652.

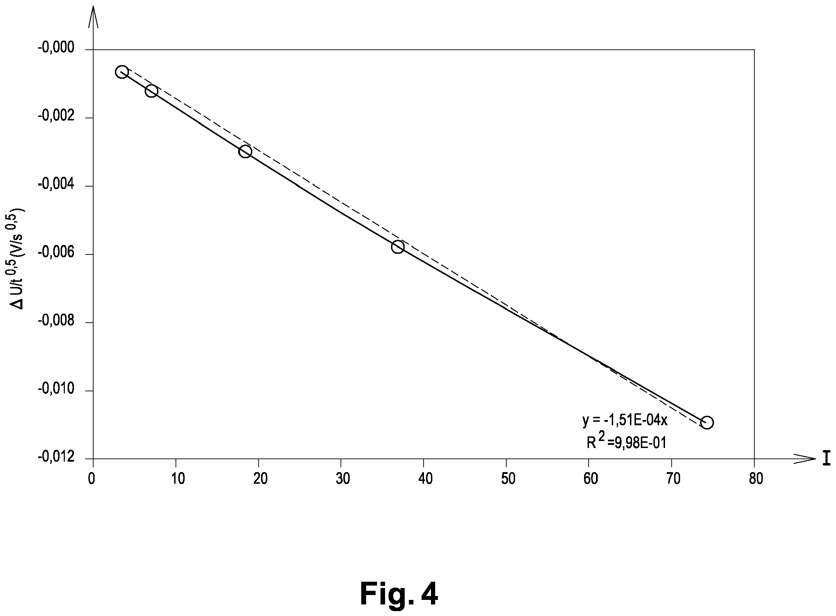

La figure 4 illustre, d'une part, l'évolution de $\Delta U / \sqrt{t}$ en fonction de l'intensité I, ceci pour les valeurs $I_1$ = 74 A, $I_2$ = 37 A, $I_3$ =18,5 A, $I_4$ = 7,4 A et $I_5$ =3,7A de la figure 3. On constate que $\Delta U / \sqrt{t}$ décroît linéairement avec I. Et en effet, une méthode de linéarisation montre que la variation de $\Delta U / \sqrt{t}$ en fonction de $I$ peut être approchée par la droite d'équation $\Delta U / \sqrt{t} = \beta \times I$ de pente $\beta$ = -0,000151 et d'ordonnée nulle à l'origine, ceci avec un coefficient de corrélation $R^2$ = 0,998.

La pente $\beta$ révèle la sensibilité de la cellule au courant sur des constantes de temps importantes, c'est-à-dire des phénomènes de diffusion. La pente $\beta$ indique la capacité de la cellule à fonctionner à des courants importants : plus la valeur absolue de la pente $\beta$ augmente, plus la cellule est sensible à l'utilisation de forts courants.

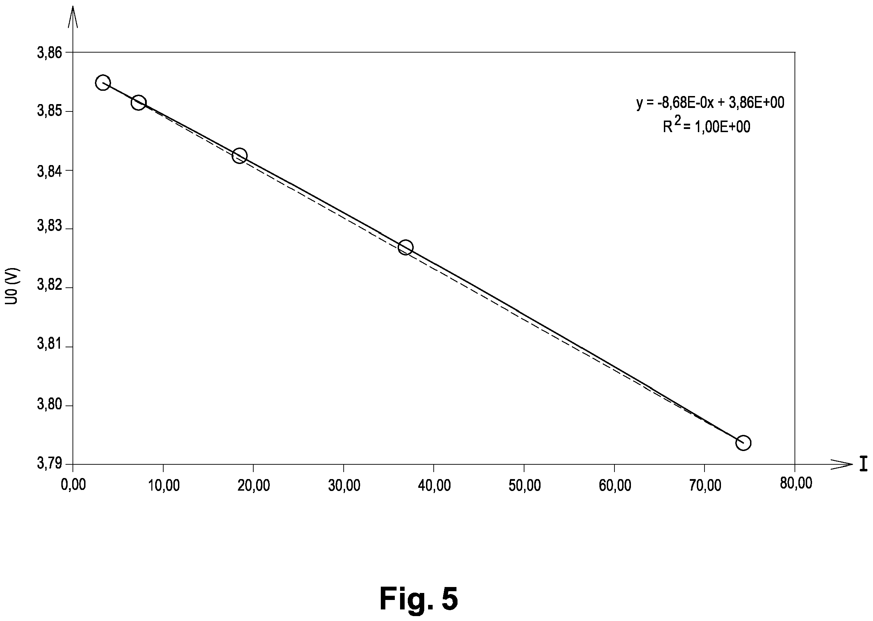

La figure 5 illustre, d'autre part, l'évolution de l'ordonnée à l'origine $U_{0,I}$ des courbes illustrées par la figure 3, en fonction de l'intensité I, ceci pour les valeurs $I_1$ = 74 A, $I_2$ = 37 A, $I_3$ =18,5 A, $I_4$ = 7,4 A et $I_5$ = 3,7 A de la figure 3. On constate que $U_{0,I}$ décroît linéairement avec I. Et en effet, une méthode de linéarisation montre que la variation de $U_{0,I}$ en fonction de $I$ peut être approchée par la droite d'équation $U_{0,I} = \gamma \times I + OCV$ de pente $\gamma$ = -0,000868 et d'ordonnée à l'origine $OCV$ = 3,86, ceci avec un coefficient de corrélation $R^2$ = 1. La pente $\gamma$ correspond quant à elle à la résistance interne de la cellule, qui vaut donc 0,868 milliohms (mΩ) à ce niveau de charge de 40% et qui correspond à une impédance mesurée à 3,5 hertz (Hz).

Puisqu'elle correspond à la résistance interne de la cellule, la pente $\gamma$ donne donc également des indications sur le $SOH_P$ de la cellule : plus la pente $\gamma$ augmente, plus le $SOH_P$ de la cellule est dégradé. De manière plus précise que l'ordonnée à l'origine $U_{0,I}$ en fonction de l'intensité I, la pente $\gamma$ estimée à partir des $U_{0,I}$ donne une indication sur la capacité de la cellule à fonctionner à des temps courts, c'est-à-dire à hautes fréquences. Elle donne une indication sur la résistance à hautes fréquences de la cellule qui, si elle est élevée, peut s'expliquer par un problème de connectique ou de vieillissement important de la cellule.

Dans ce dernier cas, les coefficients $\alpha_I$ et $\beta$ devraient indiquer un vieillissement. Donc si les coefficients $\alpha_I$ et $\beta$ sont acceptables et que le coefficient $\gamma$ ne l'est pas, on peut déduire que le problème à hautes fréquences est dû à un problème de connectique.

Une fois les coefficients $\alpha_I$, $\beta$, $U_{0,I}$ et $\gamma$ calculés conformément à la présente invention, on peut les exploiter de différentes manières.

Comme explicité précédemment, une première manière est de les utiliser à des fins de diagnostic de la cellule, afin notamment d'estimer sa capacité à fonctionner en puissance, c'est-à-dire d'estimer son SOH$_P$, voire même de diagnostiquer un défaut de connectique. Par exemple, pour $\alpha_I$, $\beta$ et $\gamma$, on peut calculer un ratio entre la valeur calculée à l'instant courant et la valeur calculée initialement, à savoir $\alpha_{I,BOL}$, $\beta_{BOL}$ et $\gamma_{BOL}$ respectivement où l'abbréviation anglo-saxonne « BOL » signifie « Beginning Of Life ». On peut ainsi observer l'évolution

relative des ratios $\dfrac{\alpha_I}{\alpha_{I,BOL}}$ , $\dfrac{\beta}{\beta_{BOL}}$ et $\dfrac{\gamma}{\gamma_{BOL}}$ :

si un coefficient à un moment donné augmente trop par rapport à sa valeur initiale, tandis que les autres coefficients, eux, montrent une évolution attendue, alors la cellule présente sans doute un défaut de connectique. Il est également possible d'observer des ratios du type $\dfrac{\gamma}{\beta}$

ou $\dfrac{\gamma}{\alpha_I}$ . Dans l'exemple illustré par les figures, au cours de la vie de la cellule, le ratio $\gamma_\beta$ varie entre 4,59 et 5,78. Cependant, un défaut de connectique de 0,2m$\Omega$ fait passer cette variation entre 5,78 et 6,814 tandis qu'un défaut de 1m$\Omega$ fait passer cette variation entre 10,56 et 11,17. En estimant au préalable ces différentes valeurs, il est possible de détecter des problèmes de connectiques en début de vie et lors de la vie de la cellule.

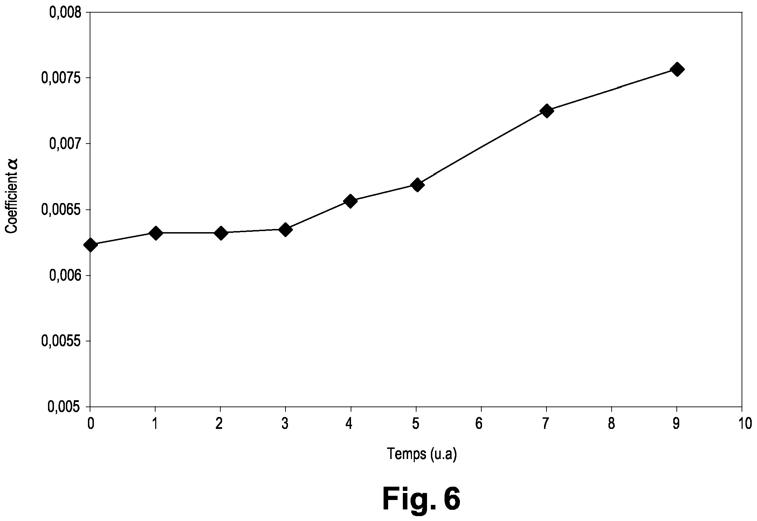

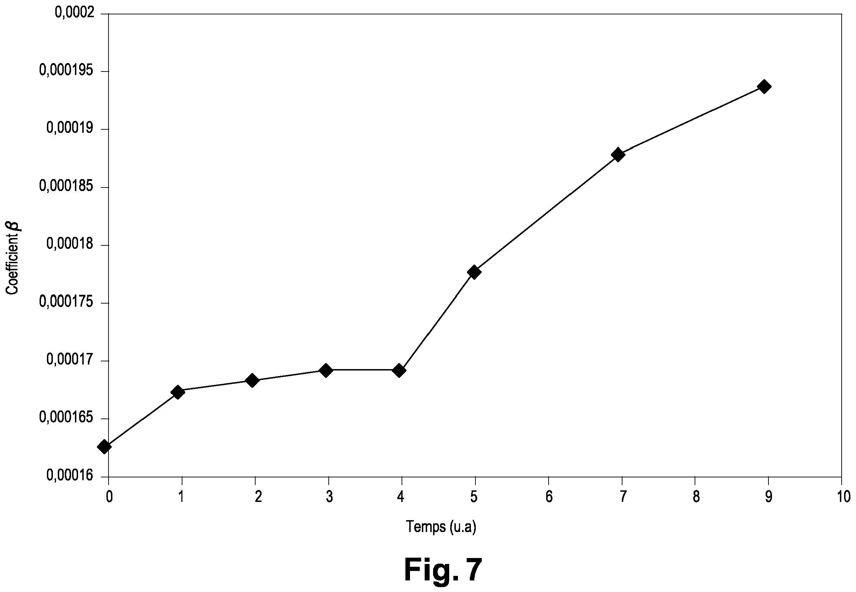

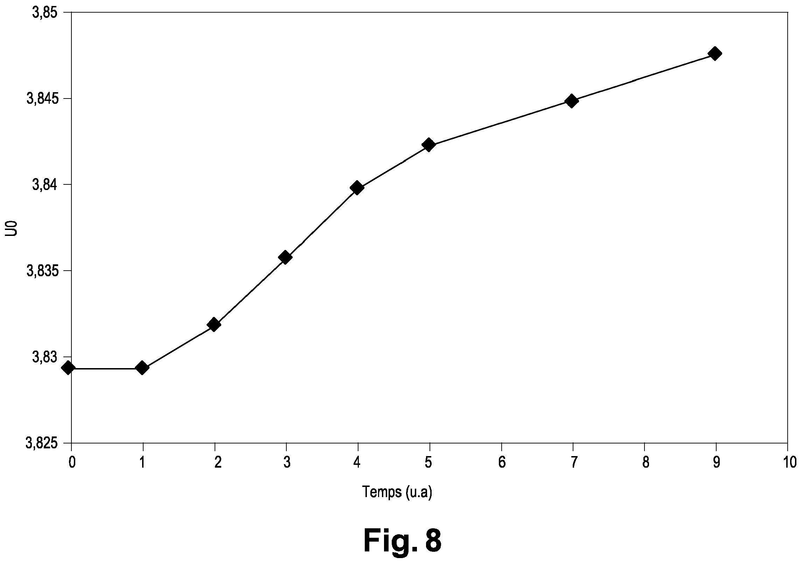

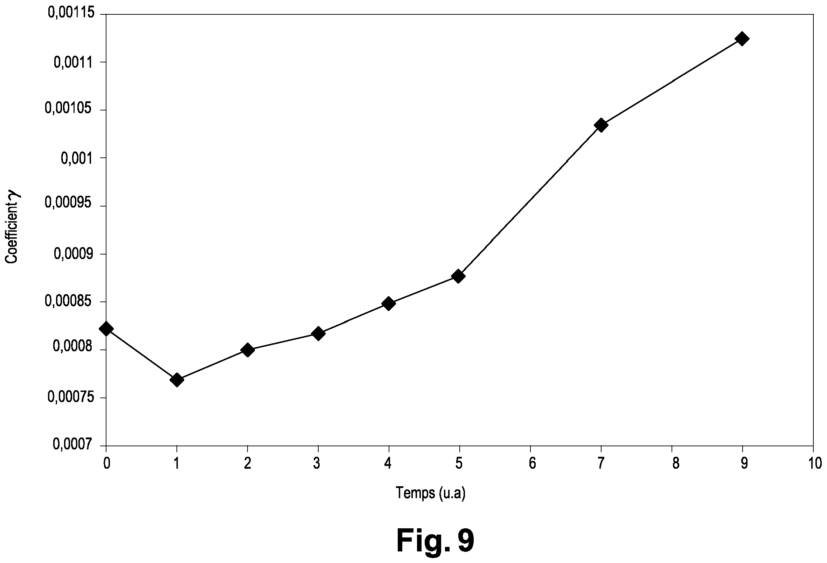

Une autre manière de les exploiter est d'estimer le SOH$_E$ de la cellule en utilisant des tables ou des graphes de vieillissement, comme les graphes illustrés aux figures 6, 7, 8 et 9 pour la pente $\alpha_I$, la pente $\beta$, l'ordonnée à l'origine $U_{0,I}$ et la pente $\gamma$ respectivement. Ces graphes associent, à des valeurs desdits coefficients, des valeurs dans une unité arbitraire (u.a.), ces valeurs dans une unité arbitraire caractérisant le vieillissement d'une cellule. Par exemple, une valeur 0 en abscisse caractérise le début de la vie de la cellule et une valeur 9 caractérise la fin de la vie de la cellule. Ces graphes sont remplis préalablement à l'utilisation de la cellule, lors de campagnes d'étude du processus de vieillissement des cellules tout au long de leur vie. Ainsi, d'après la figure 6, la pente $\alpha_I$ croît de sensiblement 0,0062 en début de vie de la cellule jusqu'à sensiblement 0,0076 en fin de vie de la cellule. D'après la figure 7, la pente $\beta$ croît de sensiblement 0,000163 en début de vie de la cellule jusqu'à sensiblement 0,000194 en fin de vie de la cellule. D'après la figure 8, l'ordonnée à l'origine $U_{0,I}$ croît de sensiblement 3,829 en début de vie de la cellule jusqu'à sensiblement 3,848 en fin de vie de la cellule. Enfin, d'après la figure 9, la pente $\gamma$ décroît d'abord de sensiblement 0,00082 à sensiblement 0,00077 en début de vie de la cellule, avant de croître jusqu'à sensiblement 0,00112 en fin de vie de la cellule.

Une autre manière d'exploiter les coefficients $\alpha_I$, $\beta$, $U_{0,I}$ et $\gamma$ calculés conformément à la présente invention est de comparer une cellule à une autre dans un module ou un pack comportant plusieurs cellules, ou encore de manière à comparer l'évolution de divers types de cellules dans le cas de cellules basées sur des chimies différentes ou n'étant pas issues du même fournisseur.

L'invention décrite précédemment a encore pour principal avantage que, ne nécessitant qu'une mise à jour logicielle des dispositifs actuels d'estimation de l'état de santé, elle a un coût de déploiement très faible.

**Revendications**

1. Procédé pour estimer l'état de santé d'une cellule électrochimique de stockage d'énergie électrique, le procédé comportant :

   • une étape d'application à la cellule d'au moins un pic de courant d'intensité $I_1$, le pic de courant traversant la cellule ;
   • une étape de mesure de la variation, en fonction du temps $t$ s'écoulant après l'application du pic de courant, de la tension U aux bornes de la cellule ;

   le procédé étant **caractérisé en ce qu'**il comporte une étape de calcul d'au moins un coefficient $\alpha_{I_1}$ et d'au moins un coefficient $U_{0,I_1}$ tels que la fonction

   $$\sqrt{t} \to \alpha_{I_1} \times \sqrt{t} + U_{0,I_1}$$ est une approximation linéaire de la variation de la tension U en fonction de $\sqrt{t}$ pour $\sqrt{t} \geq C$ , où $C > 0$.

2. Procédé selon la revendication 1, **caractérisé en ce que**, les coefficients $\alpha_{I_1}$ et $U_{0,I_1}$ ayant été calculés une première fois en début de vie de la cellule, le procédé comporte :

   • une étape de calcul du ratio de la valeur couramment calculée de $\alpha_{I_1}$ par rapport à sa valeur calculée en début de vie, une augmentation du coefficient $\alpha_{I_1}$ au-delà d'une valeur prédéterminée dudit ratio indiquant une incapacité de la cellule à délivrer un courant dans ses gammes de puissance les plus élevées, et/ou ;

• une étape de calcul du ratio de la valeur couramment calculée de $U_{0,I_1}$ par rapport à sa valeur calculée en début de vie, une augmentation du coefficient $U_{0,I_1}$ au-delà d'une valeur prédéterminée dudit ratio indiquant une incapacité de la cellule à délivrer un courant dans ses gammes de puissance les plus élevées.

**3.** Procédé selon la revendication 1, **caractérisé en ce que**, des tables ou des graphes de vieillissement ayant été remplies au préalable, le procédé comporte :

• une étape de comparaison de la valeur couramment calculée de $\alpha_{I_1}$ avec des valeurs contenues dans une table ou un graphe de vieillissement associant des niveaux de vieillissement à des valeurs de $\alpha_{I_1}$, de manière à déduire le niveau de vieillissement de la cellule, et/ou ;
• une étape de comparaison de la valeur couramment calculée de $U_{0,I_1}$ avec des valeurs contenues dans une table ou un graphe de vieillissement associant des niveaux de vieillissement à des valeurs de $U_{0,I_1}$, de manière à déduire le niveau de vieillissement de la cellule.

**4.** Procédé selon la revendication 1, **caractérisé en ce que**, une pluralité de pics de courant d'intensités $(I_n)_{n \geq 2}$ étant appliqués à la cellule $(I_1, I_2, I_3, I_4, I_5)$, il comporte en outre une étape de calcul d'un coefficient $\beta$ tel que la fonction $I \to \beta \times I$ est une approximation linéaire de la variation de $\dfrac{\Delta U}{\sqrt{t}}$ en fonction de $I$.

**5.** Procédé selon la revendication 4, **caractérisé en ce que**, le coefficient $\beta$ ayant été calculé une première fois en début de vie de la cellule, le procédé comporte une étape de calcul du ratio de la valeur couramment calculée de $\beta$ par rapport à sa valeur calculée en début de vie, une augmentation du coefficient $\beta$ au-delà d'une valeur prédéterminée dudit ratio indiquant une incapacité de la cellule à délivrer un courant dans ses gammes de puissance les plus élevées.

**6.** Procédé selon la revendication 4, **caractérisé en ce que**, des tables ou des graphes de vieillissement ayant été remplies au préalable, le procédé comporte, une étape de comparaison de la valeur couramment calculée de $\beta$ avec des valeurs contenues dans une table ou un graphe de vieillissement associant des niveaux de vieillissement à des valeurs de $\beta$, de manière à déduire le niveau de vieillissement de la cellule.

**7.** Procédé selon la revendication 4, **caractérisé en ce qu'**il comporte en outre une étape de calcul d'un coefficient $\gamma$ tel que la fonction $I \to \gamma \times I + OCV$, où OCV est la tension en circuit ouvert de la cellule, est une approximation linéaire de la variation de $U_{0,I}$ en fonction de $I$.

**8.** Procédé selon la revendication 7, **caractérisé en ce que**, le coefficient $\gamma$ ayant été calculé une première fois en début de vie de la cellule, le procédé comporte une étape de calcul du ratio de la valeur couramment calculée de $\gamma$ par rapport à sa valeur calculée en début de vie, une augmentation du coefficient $\gamma$ au-delà d'une valeur prédéterminée dudit ratio indiquant une incapacité de la cellule à délivrer un courant dans ses gammes de puissance les plus élevées.

**9.** Procédé selon la revendication 8, **caractérisé en ce que**, des tables ou des graphes de vieillissement ayant été remplies au préalable, le procédé comporte, une étape de comparaison de la valeur couramment calculée de $\gamma$ avec des valeurs contenues dans une table ou un graphe de vieillissement associant des niveaux de vieillissement à des valeurs de $\gamma$, de manière à déduire le niveau de vieillissement de la cellule.

**Patentansprüche**

**1.** Verfahren zur Schätzung des Gesundheitszustands einer elektrochemischen Zelle zur Speicherung von elektrischer Energie, wobei das Verfahren umfasst:

• einen Schritt des Anlegens wenigstens einer Stromspitze mit der Stromstärke $I_1$ an die Zelle, wobei die Stromspitze durch die Zelle fließt;
• einen Schritt der Messung der Änderung der Spannung U an den Klemmen der Zelle in Abhängigkeit von der nach dem Anlegen der Stromspitze vergangenen Zeit $t$;

wobei das Verfahren **dadurch gekennzeichnet ist, dass** es einen Schritt der Berechnung wenigstens eines Koeffizienten $\alpha_{I_1}$ und wenigstens eines Koeffizienten $U_{0,I_1}$ umfasst, derart, dass die Funktion

$$\sqrt{t} \to \alpha_{I_1} \times \sqrt{t} + U_{0,I_1}$$ eine lineare Approximation der Änderung der Spannung U in Abhängigkeit von $\sqrt{t}$ für $\sqrt{t} \geq C$ ist, wobei $C > 0$ ist.

**2.** Verfahren nach Anspruch 1, **dadurch gekennzeichnet, dass**, wenn die Koeffizienten $\alpha_{I_1}$ und $U_{0,I_1}$ ein erstes Mal zu Beginn der Lebensdauer der Zelle berechnet worden sind, das Verfahren umfasst:

• einen Schritt der Berechnung des Verhältnisses des aktuell berechneten Wertes von $\alpha_{I_1}$ zu

dessen zu Beginn der Lebensdauer berechnetem Wert, wobei eine Erhöhung des Koeffizienten $\alpha_{I_1}$ über einen vorbestimmten Wert des Verhältnisses hinaus anzeigt, dass die Zelle nicht in der Lage ist, einen Strom in ihren höchsten Leistungsbereichen zu liefern, und/oder

• einen Schritt der Berechnung des Verhältnisses des aktuell berechneten Wertes von $U_{0,I_1}$ zu dessen zu Beginn der Lebensdauer berechnetem Wert, wobei eine Erhöhung des Koeffizienten $U_{0,I_1}$ über einen vorbestimmten Wert des Verhältnisses hinaus anzeigt, dass die Zelle nicht in der Lage ist, einen Strom in ihren höchsten Leistungsbereichen zu liefern.

3. Verfahren nach Anspruch 1, **dadurch gekennzeichnet, dass**, wenn Alterungstabellen oder -diagramme im Voraus erstellt worden sind, das Verfahren umfasst:

  • einen Schritt des Vergleichs des aktuell berechneten Wertes von $\alpha_{I_1}$ mit Werten, die in einer Alterungstabelle oder einem Alterungsdiagramm enthalten sind, die bzw. das Alterungsgrade mit Werten von $\alpha_{I_1}$ verknüpft, um so den Alterungsgrad der Zelle abzuleiten, und/oder
  • einen Schritt des Vergleichs des aktuell berechneten Wertes von $U_{0,I_1}$ mit Werten, die in einer Alterungstabelle oder einem Alterungsdiagramm enthalten sind, die bzw. das Alterungsgrade mit Werten von $U_{0,I_1}$ verknüpft, um so den Alterungsgrad der Zelle abzuleiten.

4. Verfahren nach Anspruch 1, **dadurch gekennzeichnet, dass** es, wenn mehrere Stromspitzen mit Stromstärken $(I_n)_{n \geq 2}$ an die Zelle angelegt werden $(I_1, I_2, I_3, I_4, I_5)$, außerdem einen Schritt der Berechnung eines Koeffizienten $\beta$ umfasst, derart, dass die Funktion $I \rightarrow \beta \times I$ eine lineare Approximation der Änderung von $\dfrac{\Delta U}{\sqrt{t}}$ in Abhängigkeit von $I$ ist.

5. Verfahren nach Anspruch 4, **dadurch gekennzeichnet, dass**, wenn der Koeffizient $\beta$ ein erstes Mal zu Beginn der Lebensdauer der Zelle berechnet worden ist, das Verfahren einen Schritt der Berechnung des Verhältnisses des aktuell berechneten Wertes von $\beta$ zu dessen zu Beginn der Lebensdauer berechnetem Wert umfasst, wobei eine Erhöhung des Koeffizienten $\beta$ über einen vorbestimmten Wert des Verhältnisses hinaus anzeigt, dass die Zelle nicht in der Lage ist, einen Strom in ihren höchsten Leistungsbereichen zu liefern.

6. Verfahren nach Anspruch 4, **dadurch gekennzeichnet, dass**, wenn Alterungstabellen oder -diagramme im Voraus erstellt worden sind, das Verfahren einen Schritt des Vergleichs des aktuell berechneten Wertes von $\beta$ mit Werten umfasst, die in einer Alterungstabelle oder einem Alterungsdiagramm enthalten sind, die bzw. das Alterungsgrade mit Werten von $\beta$ verknüpft, um so den Alterungsgrad der Zelle abzuleiten.

7. Verfahren nach Anspruch 4, **dadurch gekennzeichnet, dass** es außerdem einen Schritt der Berechnung eines Koeffizienten $\gamma$ umfasst, derart, dass die Funktion $I \rightarrow \gamma \times I + OCV$, wobei OCV die Leerlaufspannung der Zelle ist, eine lineare Approximation der Änderung von $U_{0,I}$ in Abhängigkeit von $I$ ist.

8. Verfahren nach Anspruch 7, **dadurch gekennzeichnet, dass**, wenn der Koeffizient $\gamma$ ein erstes Mal zu Beginn der Lebensdauer der Zelle berechnet worden ist, das Verfahren einen Schritt der Berechnung des Verhältnisses des aktuell berechneten Wertes von $\gamma$ zu dessen zu Beginn der Lebensdauer berechnetem Wert umfasst, wobei eine Erhöhung des Koeffizienten $\gamma$ über einen vorbestimmten Wert des Verhältnisses hinaus anzeigt, dass die Zelle nicht in der Lage ist, einen Strom in ihren höchsten Leistungsbereichen zu liefern.

9. Verfahren nach Anspruch 8, **dadurch gekennzeichnet, dass**, wenn Alterungstabellen oder -diagramme im Voraus erstellt worden sind, das Verfahren einen Schritt des Vergleichs des aktuell berechneten Wertes von $\gamma$ mit Werten umfasst, die in einer Alterungstabelle oder einem Alterungsdiagramm enthalten sind, die bzw. das Alterungsgrade mit Werten von $\gamma$ verknüpft, um so den Alterungsgrad der Zelle abzuleiten.

**Claims**

1. Method for estimating the state of health of an electrochemical cell for storing electrical energy, the method comprising:

  • a step for applying to the cell at least one current peak of intensity $I_1$, the current peak flowing through the cell;
  • a step for measuring the variation, as a function of the time $t$ that has passed after the application of the current peak, of the voltage U across the terminals of the cell;

the method being **characterized in that** it comprises a step for calculating at least one coefficient $\alpha_{I_1}$ and at least one coefficient $U_{0,I_1}$ such that the function

$$\sqrt{t} \rightarrow \alpha_{I_1} \times \sqrt{t} + U_{0,I_1}$$ is a linear approximation of the variation of the voltage U as a function of $\sqrt{t}$ for $\sqrt{t} \geq C$ , where $C > 0$.

2. Method according to Claim 1, **characterized in that**, the coefficients $\alpha_{I_1}$ and $U_{0,I_1}$ having been calculated a first time at the beginning of life of the cell, the method comprises:

   • a step for calculating the ratio of the value currently calculated of $\alpha_{I_1}$ with respect to its value calculated at the beginning of life, an increase of the coefficient $\alpha_{I_1}$ beyond a predetermined value of said ratio indicating an incapacity of the cell to deliver a current in its highest ranges of power, and/or;
   • a step for calculating the ratio of the value currently calculated of $U_{0,I_1}$ with respect to its value calculated at the beginning of life, an increase in the coefficient $U_{0,I_1}$ beyond a predetermined value of said ratio indicating an incapacity of the cell to deliver a current in its highest ranges of power.

3. Method according to Claim 1, **characterized in that**, tables or graphs of aging having been filled out beforehand, the method comprises:

   • a step for comparing the value currently calculated of $\alpha_{I_1}$ with values contained in a table or a graph of aging associating levels of aging with values of $\alpha_{I_1}$, in such a manner as to deduce the level of aging of the cell, and/or;
   • a step for comparing the value currently calculated of $U_{0,I_1}$ with values contained in a table or a graph of aging associating levels of aging with values of $U_{0,I_1}$, in such a manner as to deduce the level of aging of the cell.

4. Method according to Claim 1, **characterized in that**, a plurality of current peaks of intensities $(I_n)_{n \geq 2}$ being applied to the cell $(I_1, I_2, I_3, I_4, I_5)$, it furthermore comprises a step for calculating a coefficient $\beta$ such that the function $I \rightarrow \beta \times I$ is a linear approximation of the variation of $\Delta U / \sqrt{t}$ as a function of $I$.

5. Method according to Claim 4, **characterized in that**, the coefficient $\beta$ having been calculated a first time at the beginning of life of the cell, the method comprises a step for calculating the ratio of the value currently calculated of $\beta$ with respect to its value calculated at the beginning of life, an increase in the coefficient $\beta$ beyond a predetermined value of said ratio indicating an incapacity of the cell to deliver a current in its highest ranges of power.

6. Method according to Claim 4, **characterized in that**, tables or graphs of aging having been filled out beforehand, the method comprises a step for comparing the value currently calculated of $\beta$ with values contained in a table or a graph of aging associating levels of aging with values of $\beta$, in such a manner as to deduce the level of aging of the cell.

7. Method according to Claim 4, **characterized in that** it furthermore comprises a step for calculating a coefficient $\gamma$ such that the function $I \rightarrow \gamma \times I + OCV$, where OCV is the open circuit voltage of the cell, is a linear approximation of the variation of $U_{0,I}$ as a function of $I$.

8. Method according to Claim 7, **characterized in that**, the coefficient $\gamma$ having been calculated a first time at the beginning of life of the cell, the method comprises a step for calculating the ratio of the value currently calculated of $\gamma$ with respect to its value calculated at the beginning of life, an increase in the coefficient $\gamma$ beyond a predetermined value of said ratio indicating an incapacity of the cell to deliver a current in its highest ranges of power.

9. Method according to Claim 8, **characterized in that**, tables or graphs of aging having been filled out beforehand, the method comprises a step for comparing the value currently calculated of $\gamma$ with values contained in a table or a graph of aging associating levels of aging with values of $\gamma$, in such a manner as to deduce the level of aging of the cell.

**Fig. 1**

**Fig. 2**

EP 3 004 905 B1

**Fig. 3**

$y = -0,0007x + 3,8546$
$R^2 = 0,9652$

$y = -0,0012x + 3,8515$
$R^2 = 0,9938$

$y = -0,003x + 3,8424$
$R^2 = 0,9989$

$y = -0,0058x + 3,8268$
$R^2 = 0,9981$

$y = -0,011x + 3,7936$
$R^2 = 0,9984$

EP 3 004 905 B1

Fig. 4

**Fig. 5**

EP 3 004 905 B1

**Fig. 6**

**Fig. 7**

**Fig. 8**

Fig. 9

**EP 3 004 905 B1**

## RÉFÉRENCES CITÉES DANS LA DESCRIPTION

### Documents brevets cités dans la description

- US 6653817 B
- US 20120310565 A